Europäisches Patentamt

European Patent Office

Office européen des brevets

(19)

(11) Veröffentlichungsnummer: **0 017 885**

**B1**

(12) **EUROPÄISCHE PATENTSCHRIFT**

(45) Veröffentlichungstag der Patentschrift: **04.07.84**

(21) Anmeldenummer: **80101847.4**

(22) Anmeldetag: **08.04.80**

(51) Int. Cl.³: **H 01 F 31/00, H 05 K 9/00, H 04 R 23/00**

(54) **Korona-Lautsprecher.**

(30) Priorität: **13.04.79 FR 7909448**

(43) Veröffentlichungstag der Anmeldung:
**29.10.80 Patentblatt 80/22**

(45) Bekanntmachung des Hinweises auf die Patenterteilung:
**04.07.84 Patentblatt 84/27**

(84) Benannte Vertragsstaaten:
**AT BE CH DE GB IT LI LU NL SE**

(56) Entgegenhaltungen:
DE - A - 2 033 682
DE - A - 2 155 219
DE - C - 654 510
FR - A - 1 041 790
FR - A - 2 061 547
FR - A - 2 274 147
GB - A - 499 037
GB - A - 562 902
US - A - 2 296 678
US - A - 2 314 309
US - A - 2 768 246
US - A - 3 177 288
US - A - 3 260 979
US - A - 3 376 523
US - A - 4 306 120

(73) Patentinhaber: **Klein, Siegfried, Dr.**
**42, rue de la Tour d'Auvergne**
**F-75009 Paris (FR)**

(72) Erfinder: **Klein, Siegfried, Dr.**
**42, rue de la Tour d'Auvergne**
**F-75009 Paris (FR)**

(74) Vertreter: **Freischem, Werner, Dipl.-Ing. et al,**
**Patentanwälte Dipl.-Ing. W. Freischem Dipl.-Ing.**
**I. Freischem An Gross St. Martin 2**
**D-5000 Köln 1 (DE)**

Courier Press, Leamington Spa, England.

## Beschreibung

Die Erfindung bezieht sich auf einen Korona-Lautsprecher mit einem Hochfrequenz-Generator (Oszillator) mit einem Modulations-Transformator, einem Netz-Transformator, einem Metallgehäuse, das einen Faraday-Käfig zur Verhinderung einer Abstrahlung einer vom Hochfrequenzgenerator ausgehenden elektromagnetischen Störstrahlung bildet.

Korona-Lautsprecher, die u.a. in der FR - A - 1 041 790 und den US - A - 2 768 246 und US - A - 3 177 288 beschrieben sind, haben den Nachteil, daß trotz metallischer Abschirmung das Abstrahlen störender elektromagnetischer Wellen nicht völlig verhindert wird.

Bei diesen Korona-Lautsprechern befindet sich der Netztransformator sowie der Hochfrequenz-Oszillator innerhalb einer metallischen Abschirmung, die eine Abstrahlung elektromagnetischer Wellen nach außen verhindert. Trotzdem kann man feststellen, daß elektromagnetische Wellen sich über die elektrischen Verbindungsleitungen, welche durch die metallische Abschirmung hindurchgeführt sind, ausbreiten. Diese störenden elektromagnetischen Wellen können zwar weitgehend durch sorgfältig ausgewählte Selbstinduktionen und Kondensatoren in den Zuleitungen unterdrückt werden, trotz dieser Maßnahmen können geringe Abstrahlungen elektromagnetischer Wellen über die Zuleitungen nicht vermieden werden. Auch wenn diese Abstrahlungen nur 100 Mikrovolt betragen, können sie die Funktion verschiedener Haushaltsgeräte, insbesondere Fernsehempfänger, stören.

Aufgabe der vorliegenden Erfindung ist es, die Nachteile der bekannten Korona-Lautsprecher zu vermeiden und ein Gerät zu schaffen, bei dem die Ausbreitung elektromagnetischer Wellen unterbunden ist.

Diese Aufgabe wird dadurch gelöst, daß die Sekundärwicklung des Netztransformators und des Modulationstransformators innerhalb des Metallgehäuses angeordnet sind und zwischen der Sekundärwicklung und der Primärwicklung eine dünne metallische Wand angeordnet ist, die einen Teil des Metallgehäuses bildet.

Die einzelnen Wicklungen der Transformatoren sind in bezug auf die Weiterleitung elektromagnetischer Wellen nach außen hin vollständig voneinander isoliert, magnetisch sind sie jedoch durch die dünne metallische Wand hindurch miteinander verbunden.

Vorteilhafterweise besteht die dünne metallische Wand aus einem praktisch amagnetischen und eine sehr geringe spezifische Leitfähigkeit aufweisenden Metall. Durch diese Folie kann das Magnetfeld des Transformators hindurchgreifen, sie bildet jedoch zusammen mit den übrigen Teilen der metallischen Abschirmung ein für elektromagnetische Wellen dichtes Gehäuse.

Transformatoren mit voneinander unabhängigen Primär- und Sekundärwicklungen, die durch eine Metallwand voneinander getrennt sind, sind seit langem bekannt. Diese bekannten Transformatoren dienen dort einem anderen Zweck. In der DE - C - 654 510 wird diese transformatorische Kopplung benutzt, um ein Fernzählwerk leitungslos an einen Maximumzähler anzuschließen. In der GB - A - 562 902 dient die transformatorische Kopplung dazu, Hochfrequenz-Zündelektroden von Ölbrennern so abzusichern, daß sie keine Störnug des Radioempfanges verursachen. In der GB - A - 499 037 dient die transformatorische Kopplung dazu, Energie leitungslos durch eine Wand hindurch, z.B. in einen Behälter, z.B. in einen Gasometer oder in einen Öltank, einzuleiten. Bei dem Gerät nach der FR - A - 2 061 547 hat die transformatorische Kopplung den Zweck, Signale in einen metallisch gegen elektromagnetische Störstrahlen abgeschirmten Raum einzuleiten.

Weitere Ausbildungen der Erfindung ergeben sich aus den abhangigen Ansprüchen, deren Merkmale zum Teil aus den genannten Entgegenhaltungen bekannt sind.

Ausführungsbeispiele der Erfindung sind in der Zeichnung dargestellt und werden nun näher erläutert. Es zeigen

Fig. 1 eine Seitenansicht des Abschirmgehäuses eines Korona-Lautsprechers gemäß der Erfindung, teilweise als Schnittbild ausgeführt,

Fig. 2 eine Draufsicht auf das Gehäuse gemäß Fig. 1, einzelne Bauteile sind aus Gründen der deutlicheren Darstellung nicht gezeigt,

Fig. 3 eine Schnittansicht entlang der Schnittlinie III—III in Fig. 2 und

Fig. 4 eine Darstellung entsprechend Fig. 3 eines anderen Ausführungsbeispiels.

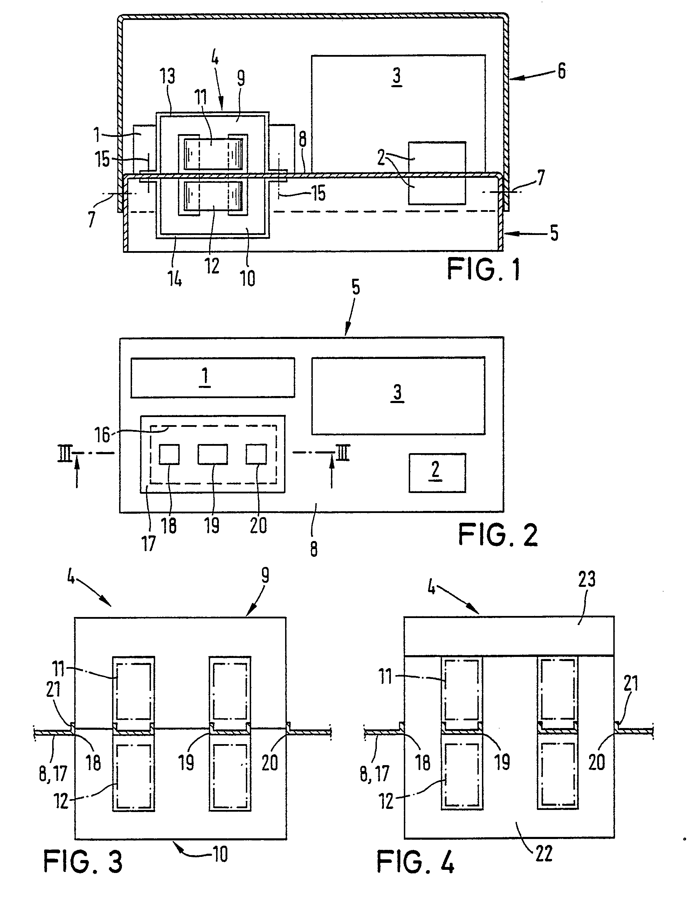

Die Fig. 1 und 2 zeigen einen HF-Oszillator 1, dessen Ausgangssignal über einen Modulationstransformator 2 moduliert wird, sowie einen HF-Transformator 3, der das modulierte Hochfrequenzsignal in eine HF-Spannung der Größenordnung von einigen Kilovolt transformiert und dessen Ausgang mit der Entladungselektrode des Korona-Lautsprechers verbunden ist. Ein Schema für eine Verbindung dieser einzelnen Bauteile untereinander ergibt sich zum Beispiel aus der FR - A - 1 041 790. Die für den Betrieb des HF-Oszillators 1 benötigte Gleichspannung wird über einen Netztransformator 4 und über eine nicht dargestellte Gleichrichter- und Siebschaltung erzeugt. Diese Bauteile sind auf einem Metallchassis 5 montiert, das von einem Metallgehäuse 6 abgedeckt ist. Dieses Gehäuse 6 ist mit dem Chassis 5 beispielsweise über Schrauben 7 lösbar verbunden. Das Chassis 5 bildet zusammen mit der oberen Platte 8 des Chassis 5 einen Faraday-Käfig, der die Ausbreitung elektromagnetischer Wellen, die vom HF-Oszillator 1 erzeugt werden, nach außen hin verhindert.

Der elektroakustustische, mit Koronaeffekt arbeitende Wandler wird unmittelbar auf dem Gehäuse 6 oder teilweise im Inneren dieses Gehäuses 6 angeordnet.

Bei den bekannten Korona-Lautsprechern sind der Modulationstransformator 2 und der Netztransformator 4 im Inneren der metallischen Abschirmung angeordnet. Um eine Ausbreitung der vom HF-Oszillator erzeugten elektromagnetischen Wellen über die elektrischen Zuleitungen nach außen hin zu vermeiden, sind die Primärwicklung und die Sekundärwicklung jedes der beiden Transformatoren 2 und 4 voneinander getrennt, wobei die eine Wicklung im Inneren, die andere Wicklung außerhalb der dünnen metallischen Wand 8 angeordnet sind. Dabei bleibt die magnetische Kopplung zwischen den beiden Wicklungen durch die Wand 8 hindurch erhalten.

Die Wicklungen des Netztransformators 4 sind in gleicher Weise wie die des Modulationstransformators 2 voneinander getrennt.

Dadurch gibt es keine einzige elektrische Verbindung, die durch die Abschirmung hindurchläuft. Wie Fig. 1 zeigt, ist der magnetische Kreis des Netztransformators 4 in zwei Teilbereiche 9 und 10. aufgeteilt, von denen der erste die Sekundärwicklung 11 und der zweite die Primärwicklung 12 trägt. Beide Teilbereiche 9, 10 des Transformators 4 sind einander gegenübergestellt auf der einen und der anderen Seite der oberen Wand 8 des Chasis 5. In dieser Position sind sie beispielsweise mittels zweier Befestigungsbügel 13 und 14 gehalten, die über Schrauben 15 an der Wand 8 befestigt sind.

Jeder der beiden Teilbereiche 9 und 10 des magnetischen Kreises wird von einem Paket Magnetbleche gebildet, die einen E-Schnitt haben. Auf dem mittleren Vorsprung, der den magnetischen Kern bildet, sind die Wicklungen 11 und 12 aufgebracht. Die beiden äußeren Schenkel des E schließen den magnetischen Kreis. Die Schenkel des Teilbereichs 9 sind in Kontakt mit der oberen Fläche der Wand 8, die Schenkel des Teilbereichs 10 befinden sich in Kontakt mit der unteren Fläche dieser metallischen Wand 8, und zwar in Ausrichtung mit den Schenkeln des Teilbereichs 9.

Damit der Transformator 4 einen guten Wirkungsgrad hat, darf die Wand 8 keinen magnetischen Nebenschluß zwischen den beiden Teilbereichen 9 und 10 des magnetischen Kreisflusses bilden. Demzufolge muß die Wand 8 aus einem amagnetischen Material hergestellt sein, das zudem so gering wie möglich magnetisch ist. Zudem muß die Wand 8, um nicht den Wirkungsgrad des Transformators zu verringern, so dünn wie möglich sein, um keinen zu großen Spalt zwischen den Teilbereichen 9 und 10 des magnetischen Kreises zu bilden. Schließlich muß die Wand 8, da sie die Schenkel geschlossen umläuft und deshalb eine Kurzschlußwindung darstellt, vorteilhafterweise aus einem Metall hergestellt sein, das eine sehr geringe elektrische Leitfähigkeit aufweist, um Verluste aufgrund des Joule-Effekts in der Wand 8 gering zu halten. Beispielsweise kann diese Wand 8 aus nichtrostendem Stahl gefertigt sein. Die Bedingung, die Wand 8 so dünn wie möglich auszubilden, ist möglicherweise nicht in Einklang zu bringen mit ausreichender mechanischer Festigkeit, die das Chassis 5 haben muß, um die einzelnen Bauteile des Gerätes tragen zu können. Um hier Abhilfe zu schaffen, kann in der Wand 8 eine große Öffnung vorgesehen sein, die mittels einer sehr dünnen rechteckförmigen Platte 17 geschlossen wird. Diese besteht aus einem magnetischen und eine geringe elektrische Leitfähigkeit besitzenden Material, insbesondere aus rostfreiem Stahl. Die Platte 17 kann über Schweißen oder andere Befestigungsverfahren an der Wand 8 befestigt sein. Die beiden Teilbereiche 9 und 10 des magnetischen Kreises werden je zu einer Seite dieser Platte 17 angeordnet, entsprechend wie dies in Fig. 1 gezeigt ist.

In Fig. 3 ist eine andere Anordnung der beiden Teilbereiche 9 und 10 des magnetischen Kreises des Transformators 4 gezeigt. In diesem Fall ist die Wand 8 oder gegebenenfalls die Platte 17, falls eine derartige vorgesehen ist, mit einer Anzahl von Öffnungen versehen, die der Zahl der Schenkel der Teilbereiche 9 und 10 des magnetischen Kreises entspricht. Dies sind im Beispiel die drei Öffnungen 18, 19 und 20, da im gezeigten Fall die Teilbereiche 9 und 10 einen E-Schnitt haben. Jede der Öffnungen 18, 19 und 20 hat Abmessungen, die exakt mit dem Querschnitt der angesprochenen Schenkel übereinstimmen. Die Schenkel des einen der beiden Teilbereiche des magnetischen Kreises, im gezeichneten Beispiel sind es diejenigen des Teilbereichs 10, reichen durch diese Öffnungen hindurch und sind den Schenkeln des anderen Teilbereichs 9 des magnetischen Kreises angefügt. Um eine perfekte Abdichtung gegenüber elektromagnetischen Strahlen zu erreichen, haben die Ränder der Öffnungen 18, 19, 20 eine Hochbiegung 21, die vorteilhafterweise in der Wand 8 oder in der Platte 17 um jede der Öffnungen 18, 19, 20 herum beim Preß- oder Stanzvorgang ausgeformt ist. Die Lappen 21 stehen in unmittelbarem Kontakt mit den Blechen des magnetischen Kreises.

In Fig. 4 ist ein zweites Ausführungsbeispiel für den Netotransformator 4 gezeigt. In diesem Fall hat der magnetische Kreis des Transformators einen Blechpaketbereich 22 in Form eines E, dessen zentraler Schenkel die Primär- und Sekundärwicklung 11 und 12 trägt, sowie ein ebenfalls aus Blechen geschichtetes Joch 23, mit dem der magnetische Fluß geschlossen wird und das die Schenkel des Teilsbereichs 22 miteinander verbindet. Bei der Montage wird zunächst die Wicklung 12 auf den zentralen Schenkel des Bereichs 22 aufgeschoben, danach werden die drei Schenkel des Bereichs 22 durch die Öffnungen 18, 19, 20 der Wand 8 oder 17 hindurchgeschoben, etwa bis zur Hälfte der Höhe dieser drei Schenkel. Daraufhin wird die Primärwicklung 11 auf den zentralen Schenkel des Bereichs 22 aufgeschoben und das Joch 23 auf den freien Enden dieser drei Schenkel angebracht. Der Transformator 4 wird — wie Fig. 1 zeigt — mittels Spannbügel 13 und 14 gehalten.

## Patentansprüche

1. Korona-Lautsprecher mit einem Hochfrequenz-Generator (Oszillator) (1), einem Modulations-Transformator (2), einem Netz-Transformator (4), einem Metallgehäuse (6), das einen Faraday-Käfig zur Verhinderung einer Abstrahlung einer vom Hochfrequenz-Generator (1) ausgehenden elektromagnetischen Störstrahlung bildet, dadurch gekennzeichnet, daß die Sekundärwicklung (11) des Netztransformators (4) und des Modulationstransformators (2) innerhalb des Metallgehäuses (6) angeordnet sind und zwischen der Sekundärwicklung (11) und der Primärwicklung (12) eine dünne metallische Wand (8, 17) angeordnet ist, die einen Teil des Metallgehäuses (6) bildet.

2. Korona-Lautsprecher nach Anspruch 1, dadurch gekennzeichnet, daß die dünne metallische Wand (8, 17) aus nichtrostendem Stahl besteht.

3. Korona-Lautsprecher nach Anspruch 1 oder 2, dadurch gekennzeichnet, daß der Eisenkörper des Transformators (4 oder 2) in zwei Teile (9, 10) geteilt ist und jeder Teil mindestens zwei parallele Schenkel aufweist, von denen der eine den Kern und der andere den Rücklauf für den magnetischen Fluß bildet, und daß die freien Enden der Schenkel beider Teile (9, 10) mit der zwischen ihnen befindlichen metallischen Wand (8, 17) in Kontakt stehen.

4. Korona-Lautsprecher nach Anspruch 1, dadurch gekennzeichnet, daß die metallische Wand (8) Öffnungen (18, 19, 20) aufweist, die genau dem Querschnitt der Schenkel des Eisenkörpers der Transformatoren (2, 4) angepaßt sind und die durch diese Öffnungen (18, 19, 20) gesteckten Schenkel des Eisenkörpers die Wand (8) ringsum berühren.

5. Korona-Lautsprecher nach Anspruch 4, dadurch gekennzeichnet, daß die Öffnungen (18, 19, 20) je einen aus der Ebene der Wand (8) aufgebogenen kragenartigen Rand (21) aufweisen, der an den durch die jeweilige Öffnung (18, 19, 20) geführten Schenkel des Eisenkörpers anliegt.

6. Korona-Lautsprecher nach Anspruch 1, dadurch gekennzeichnet, daß die dünne Wand (8) von der oberen Wand eines Metallchassis (5) gebildet ist, auf welchem die Teile des Gerätes, wie zum Beispiel Widerstände, Transformatoren (2, 3, 4), Hochfrequenz-Generator (1) und Metallgehäuse (6) befestigt sind.

7. Korona-Lautsprecher nach Anspruch 6, dadurch gekennzeichnet, daß in der oberen Wand (8) des Metallchassis (5) in den Bereichen des Netztransformators (4) und des Modulationstransformators (2) eine Ausnehmung (16) angeordnet ist, die von einer dünnen Metallfolie (17) abgedeckt ist.

## Revendications

1. Haut-parleur à effet corona, comprenant un générateur à haute fréquence (oscillateur) (1), un transformateur de modulation (2), un transformateur d'alimentation (4), une enveloppe de métal (6) qui constitue une cage de Faraday pour empêcher l'émission d'un rayonnement électromagétique parasite à partir du générateur à haute fréquence (1), caractérisé en ce que les enroulements secondaires (11) du transformateur d'alimentation (4) et du transformateur de modulation (2) sont disposés à l'intérieur de l'enveloppe de métal (6) et en ce qu'il est placé, entre les enroulements secondaires (11) et les enroulements primaires (12), une paroi métallique mince (8, 17) qui fait partie de l'enveloppe de métal (6).

2. Haut-parleur à effet corona selon la revendication 1, caractérisé en ce que la paroi métallique mince (8, 17) est faite d'acier inoxydable.

3. Haut-parleur à effet corona selon la revendication 1 ou 2, caractérisé en ce que le corps de fer du transformateur (4 ou 2) est divisé en deux parties (9, 10) et chaque partie comporte au moins deux branches parallèles, dont l'une constitue le noyau et l'autre le trajet de retour pour le flux magnétique, et en ce que les extrémités libres des branches des deux parties (9, 10) sont en contact avec le paroi métallique (8, 17) qui se trouve entre elles.

4. Haut-parleur à effet corona selon la revendication 1, caractérisé en ce que la paroi métallique (8) présente des ouvertures (18, 19, 20) qui sont adaptées exactement à la section des branches du corps de fer des transformateurs (2, 4), et en ce que les branches du corps de fer, enfilées à travers ces ouvertures (18, 19, 20) sont en contact avec la paroi (8) tout autour de celles-ci.

5. Haut-parleur à effet corona selon la revendication 4, caractérisé en ce que les ouvertures (18, 19, 20) présentent chacune un bord en forme de collet (21) qui est rabattu hors du plan de la paroi (8) et qui s'applique sur la branche du corps de fer passant à travers l'ouverture correspondante (18, 19, 20).

6. Haut-parleur à effet corona selon la revendication 1, caractérisé en ce que la paroi mince (8) est constituée par la paroi supérieure d'un châssis de métal (5) sur lequel sont fixés les éléments de l'appareil, comme par exemple des résistances, des transformateurs (2, 3, 4), le générateur à haute fréquence (1) et l'enveloppe de métal (6).

7. Haut-parleur à effet corona selon la revendication 6, caractérisé en ce qu'il est pratiqué, dans la paroi supérieure (8) du châssis de métal (5), dans les régions du transformateur d'alimentation (4) et du transformateur de modulation (2), un évidement (16) qui est fermé par une feuille mince de métal (17).

## Claims

1. A corona loudspeaker comprising a high frequency generator or oscillator (1), a modulation transformer (2), a line transformer (4), and a metal enclosure (6), said enclosure forming an electrostatic shield against electromagnetic interference radiation from the said high frequency generator (1), characterized in that the secondaries (11) of the line transformer (4) and of the modulation transformer (2) are placed within the metal enclosure (6) and between the secondary (11) and the primary (12) there is a thin metal wall (8 and 17), same forming a part of the metal enclosure (6).

2. The corona loudspeaker as claimed in claim 1 characterized in that the thin metal wall (8 and 17) is made of stainless steel.

3. The corona loudspeaker as claimed in claim 1 or claim 2 characterized in that the iron circuit of the transformer (4 or 2) is made up of two parts (9 and 10), each such part having at least two parallel legs, one of same forming the core and the other forming the return means for the magnetic flux, and in that the free ends of the legs of the two said parts (9 and 10) are in contact with the metal wall (8 and 17) placed between them.

4. The corona loudspeaker as claimed in claim 1 characterized in that the metal wall (8) has openings (18, 19 and 20) exactly answering to the cross section of the legs of the iron circuit of the transformers (2 and 4) and the legs, running through these openings (18, 19 and 20), of the iron circuit make contact with the wall (8) roundabout same.

5. The corona loudspeaker as claimed in claim 4 characterized in that the openings (18, 19 and 20) each have a collar-like edge (21) bent out of the plane of the wall (8), said edge resting against the leg, running through the opening (18, 19 and 20) therefor, of the iron circuit.

6. The corona loudspeaker as claimed in claim 1 characterized in the thin wall (8) is formed by the top wall of a metal chassis (5), on which the parts of the apparatus, as for example resistors, the transformers (2, 3 and 4), the high frequency generator (1) and the metal enclosure (6), are fixed in place.

7. The corona loudspeaker as claimed in claim 6 characterized in that in the top wall (8) of the metal chassis (5) near the line transformer (4) and the modulation transformer (2) there is a cutout (16) that is covered over by a piece of thin metal foil (17).

FIG. 1

FIG. 2

FIG. 3

FIG. 4

1